# EUROPEAN PATENT SPECIFICATION

(11) **EP 3 204 725 B1**
(45) Date of publication and mention of the grant of the patent: **09.01.2019**
(21) Application number: 14859324.7
(22) Date of filing: 06.10.2014
(51) Int. Cl.: G01D 1/04, G01D 21/00

(54) **APPARATUS FOR CUMULATIVE SENSING**
VORRICHTUNG ZUR KUMULATIVEN DETEKTION
DISPOSITIF DE DÉTECTION CUMULATIVE

(43) Date of publication of application: 16.08.2017
(73) Proprietor: Provenance Asset Group LLC, Essex, CT 06426 (US)
(72) Inventor: GARTSEEV, Ilya Borisovich, Moscow 119421 (RU); BESSONOV, Alexander Alexandrovich, Moscow 117588 (RU); KIRIKOVA, Marina Nikolaevna, Moscow 117292 (RU); BAILEY, Marc James Ashton, Cambridge CB4 3DD (GB)
(74) Representative: Möller, Christoph
(86) International application number: PCT/RU2014/000743
(87) International publication number: WO 2016/056933

(56) References cited:
- DE-A1-102011 076 105
- US-A1- 2012 092 181
- TSE NGA NG ET AL: "Solution-Processed Memristive Junctions Used in a Threshold Indicator", IEEE TRANSACTIONS ON ELECTRON DEVICES, IEEE SERVICE CENTER, vol. 58, no. 10, October 2011 (2011-10), pages 3435-3443, XP011382949, PISACATAWAY, NJ, US ISSN: 0018-9383, DOI: 10.1109/TED.2011.2162334

## Description

### TECHNICAL FIELD

The present application relates to microelectronics. In particular, the present application relates to sensors and variable resistance systems.

### BACKGROUND OF THE INVENTION

Various sensors are used in everyday objects as well as implementations of which most people are not aware. With advances in electronics, the uses of sensors have expanded beyond the more traditional fields of temperature, pressure or flow measurement, for example into MARG (magnetic angular rate gravity) and other sensors. Analog sensors such as potentiometers and force-sensing resistors are still widely used. Applications of sensors include, among other things, technical devices and electronic devices.

In operation of a technical device, continuous physical parameters that are changing with time may need to be measured. Sometimes, instead of measuring an instantaneous value of a measured parameter, a cumulative value of the parameter over time is of interest. Integrating the value of the measured signal can be done through numerical integrating of a sensor signal using an attached digital microprocessor.

The document DE 10 2011 076105 A1 describes a sensing system comprising plural memristive components that each receive the electrical signal produced by a respective sensing component. These memristive components produce independent cumulative values of the electrical signal they receive over time. The cumulative value of each of the memristive components is selectively conveyed via a switching arrangement to a processing component.

### SUMMARY

In this section, the main embodiments of the present invention as defined in the claims are described and certain definitions as well as examples forming background art and not necessarily belonging to the invention are given.

According to an example, a system is disclosed. The system comprises: a sensing unit adapted to perform measurement of a parameter and produce an electrical signal based on the measurement; and a memristive unit electrically coupled to the sensing unit and adapted to receive the produced electrical signal from the sensing unit, wherein the memristive unit is further adapted to produce a cumulative value of the received electrical signal over time. The system also comprises a processing unit electrically coupled to the memristive unit and adapted to receive the produced cumulative value from the memristive unit, wherein the processing unit is further adapted to digitize the received cumulative value.

The system may be, for example, a sensing system, an integrating sensing system, or a system for measuring cumulative values of parameters.

The sensing unit can perform the measurement e.g. by reacting to one or more parameters, or changes in the parameters, of the environment in which the sensing unit is placed.

By memristive unit is meant a unit which has memristive properties. This refers, for example, to a capability to retain a state of resistance based on the history of applied voltage and passed charge, i.e. on the history of the received electrical signal.

The memristive unit can produce a cumulative value of the received signal over time e.g. by changing its own parameters. By "producing a cumulative value over time" is meant producing a value that can be interpreted by the processing unit, e.g. a value representing conductivity of the memristive unit. The cumulative value of the received electrical signal over time can represent the cumulative value of the parameter measured by the sensing unit.

In an embodiment, the processing unit may comprise, for example, a microprocessor and an analog digital converter.

According to an embodiment, the measured parameter is selected from the group of: temperature, resistance, pressure, humidity, rotation speed, linear acceleration, magnetic field, luminance, ionizing radiation, power consumption, flow of gas or water, chemical and biological parameters, strain, and mechanical deformation. The sensing unit may be adapted to measure other parameters according to embodiments of the present invention.

According to an embodiment, the memristive unit comprises two or more memristive components.

According to an embodiment, at least one of the memristive components comprises a material selected from the group of: metal oxides, halides, nitrides, chalcogenides and organic polymers. Other memristive materials are also possible according to embodiments of the invention.

According to an embodiment, the memristive unit comprises two memristive components coupled to the sensing unit and the processing unit in parallel.

According to an embodiment, the system further comprises a switching unit adapted to selectively couple one of the memristive components to the sensing unit. The switching unit may include any suitable switch, such as a single pole double throw switch, a crossover switch or others. Selective coupling here can refer to coupling one of the memristive components at a time, or both at the same time.

According to an example, the memristive unit comprises two or more memristive components electrically coupled to the processing unit in parallel, while the sensing unit comprises the same number of sensing components. In this example, each of the sensing components is electrically coupled to one of the memristive components in series. The memristive components can therefore form pairs with the sensing components they are coupled to.

According to an embodiment, the processing unit is adapted to send a reset signal to a memristive unit. The memristive unit according to the embodiment is adapted to receive the reset signal from the processing unit and restart measurement upon receiving said signal. Restarting measurement means returning to the original state or changing state to a predetermined state before continuing.

According to an embodiment, the system may further comprise a reset unit adapted to send a reset signal to the memristive unit, wherein the memristive unit is adapted to receive the reset signal from the reset unit and restart measurement upon receiving said signal.

According to an example, the sensing unit and the memristive unit form a single device. In an example, the sensing unit and the memristive unit comprise a shared active material which is selected from the group of: transition metal dichalcogenides, partially or fully oxidized transition metal dichalcogenides and graphene-like materials. Such active material may also be the active material of the device formed by the sensing unit and the memristive unit. Alternatively, only part of the active material may be shared.

According to an embodiment, the sensing unit and a memristive unit are physically separated and electrically coupled to each other. In other words, the sensing unit and the memristive unit according to the embodiment are implemented as separate modules or devices that are coupled to each other electrically.

According to an example, a method is disclosed. The method comprises: performing measurement of a parameter by a sensing component; producing an electrical signal based on the measurement; providing the electrical signal to one or more memristive components; producing a cumulative value of the electrical signal over time at least one of the memristive components; providing the cumulative value to a processing component; and digitizing the cumulative value by the processing component.

The method may be, but not limited to, a method for sensing of a parameter, or a method for cumulative sensing of a parameter.

According to an example, the method further comprises resetting the memristive component by the processing component to restart the measurement of a parameter by the sensing component upon reaching of a threshold by the memristive component. The threshold reached by the memristive component may be detected by a threshold circuit electrically coupled to the memristive component. Alternatively, according to an example, the method can comprise periodically resetting the memristive component by the processing component to restart the measurement of a parameter by the sensing component.

According to an example, two or more memristive components are used, the method further comprising switching between the memristive components by a switching component to provide selective coupling of the memristive components to the processing component.

According to an example, the method described above can be used in electronic devices.

According to an example, an apparatus is disclosed. The apparatus comprises: at least one processor; at least one memory coupled to the at least one processor, the at least one memory comprising program code instructions which, when executed by the at least one processor, cause the apparatus to perform the methods according to any of the abovementioned examples.

According to an aspect of the present invention, an apparatus is disclosed. The apparatus comprises: a sensing component adapted to perform measurement of a parameter and produce an electrical signal based on the measurement; two memristive components adapted to receive the produced electrical signal from the sensing component, and produce a cumulative value of the received electrical signal over time; a switching component adapted to selectively couple the two memristive components to the sensing component; and a processing component adapted to receive the produced cumulative value from the two memristive components and digitize the received cumulative value, wherein the processing component is electrically coupled to the two memristive components in parallel.

The apparatus may be, for example, a sensing apparatus or an apparatus for cumulative sensing of a parameter.

According to an embodiment, the apparatus further comprises a reset component adapted to send a reset signal to the switching component. The switching component of this embodiment comprises a crossover switch electrically coupled to the two memristive components, the processing component and the reset component. The processing component is adapted to provide a control signal to the crossover switch; while the crossover switch is adapted to receive the control signal from the processing component and selectively couple the two memristive components to the sensing component and the reset component; and the two memristive components are adapted to receive the reset signal from the reset component when coupled to the reset component and restart measurement upon receiving said signal.

According to an embodiment, the apparatus further comprises a polarity detector electrically coupled to the sensing component and the switching component. The sensing component of the embodiment is adapted to produce electrical signals of opposite polarities based on the measurement of the parameter; while the switching component comprises a single pole double throw switch; and the polarity detector is adapted to detect the polarity of the electrical signal produced by the sensing component. The polarity switch is further adapted to control the single pole double throw switch based on the detected polarity.

According to an example, an apparatus is disclosed. The apparatus comprises two or more pairs of a sensing component electrically coupled to a memristive component in series, wherein the sensing components are adapted to perform measurement of a parameter and produce an electrical signal based on the measurement; the memristive components are adapted to receive the produced electrical signal from the sensing component of the same pair, and produce a cumulative value of the received electrical signal over time. The apparatus further comprises a processing component adapted to receive the produced cumulative value from the memristive components and digitize the received cumulative value, wherein the processing component is electrically coupled to the two or more pairs in parallel.

The apparatus may be, for example, a sensing apparatus or an apparatus for cumulative sensing of a parameter.

### BRIEF DESCRIPTION OF THE DRAWINGS

For a more complete understanding of example embodiments of the present invention, reference is now made to the following descriptions taken in connection with the accompanying drawings in which:
FIGURES 1a and 1b show systems according to examples;
FIGURE 2 shows a method according to an example; and
FIGURES 3a to 3c show apparatuses according to examples and embodiments.

### DETAILED DESCRIPTON OF THE EMBODIMENTS

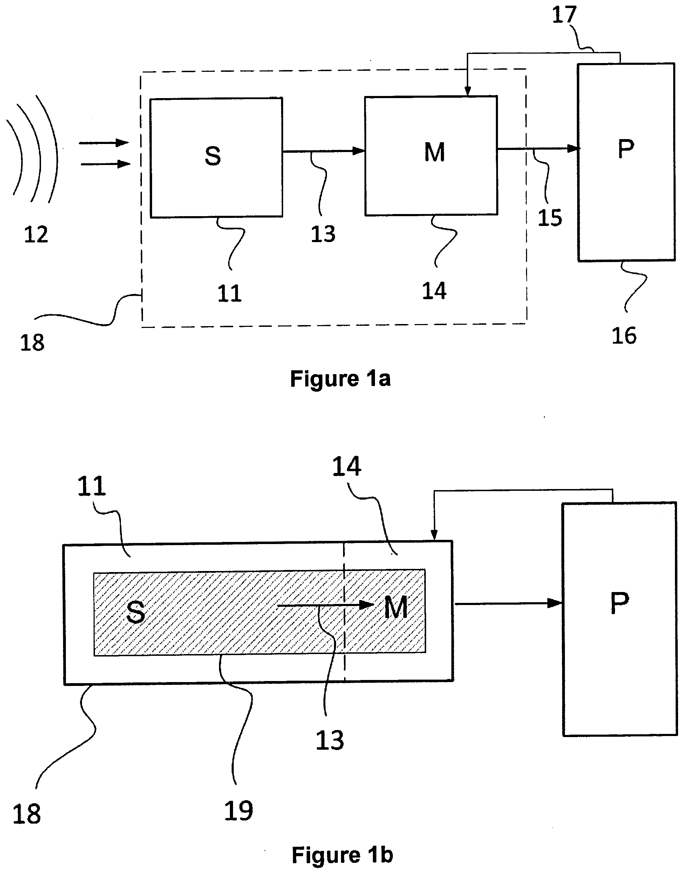

Examples as well as exemplary embodiments of the present invention and its potential advantages are understood by referring to Figures 1 through 3c of the drawings. The present invention relates to an apparatus as defined in claim 1.

Fig. 1a shows a system. The system comprises a sensing unit 11 which performs measurement of a parameter, schematically shown in 12. The parameter 12 may be temperature, resistance, pressure, humidity, rotation speed, linear acceleration, magnetic field, luminance, ionizing radiation, power consumption, flow of gas or water, chemical and biological parameters, strain, mechanical deformation or other parameters. The measurement can be done continuously or discretely with a predetermined frequency. The sensing unit 11 may have one or more sensing components, not shown individually in Fig. 1. These components may perform measurements simultaneously or selectively. The sensing unit 11 is also adapted to produce an electrical signal 13 which is based on the measurements of parameter 12. In other words, the sensing unit 11 measures a parameter 12, or a change in the parameter 12, and converts this reaction to an electrical signal 13. The sensing unit 11 may comprise, for example, an analog sensor device that converts a physical, chemical or biological parameter into an output electrical signal of certain current or voltage.

The system further comprises a memristive unit 14 which is electrically coupled to the sensing unit 11 and is adapted to receive the produced electrical signal 13. The memristive unit 14 produces a cumulative value 15 of the received electrical signal over time. The memristive unit 14 may also comprise one or more memristive components, not shown individually on Fig. 1. The memristive components may comprise a material selected from the group of: bulk metal oxides, halides, nitrides, chalcogenides and organic polymers. The memristive unit 14 may comprise two memristive components coupled to the sensing unit 11 and the processing unit 16 in parallel. The system may also comprise a switching unit (not shown in Fig. 1) which is adapted to selectively couple one of the memristive components to the sensing unit 11. This allows using the two memristive components e.g. one at a time. The memristive components may be, but are not limited to, bipolar memristors or unipolar memristors.

The memristive property of the unit 14 means that, for example, conductivity of one or more memristive components or materials comprised therein depends on the current flowing through it; more specifically it is proportional to an integral of said current over time. This can also be referred to as a "memory" function of a memristive component because its conductivity depends on the history of the electrical signal 13 passed through it. Utilizing this property of the memristive unit 14 allows to obtain a cumulative value 15 of the electrical signal 13 received by the memristive unit 14 up to a certain time by monitoring its state (e.g. conductivity) at a given moment. Since the electrical signal 13 is based on the measurement of the parameter 12, the cumulative value 15 produced by the memristive unit can also be interpreted to represent a cumulative value of the measured parameter 12.

The system also comprises a processing unit 16 adapted to receive the produced cumulative value 15 from the memristive unit 14. The processing unit 16 is further adapted to digitize the received cumulative value 15. For example, the processing unit 16 may comprise an Analog-Digital Converter (ADC) which digitizes the received value 15. The processing unit 16 may also comprise a memory which stores the digitized value, as well as a microprocessor, a microcontroller, or a programmable logic array.

In an example, the processing unit 16 may send a reset signal 17 to the memristive unit 14, wherein the memristive unit 14 is adapted to receive the reset signal 17 from the processing unit and restart measurement upon receiving said signal 17. In an example, the system may further comprise a reset unit (not shown in Fig. 1) adapted to send a reset signal to the memristive unit 14, wherein the memristive unit 14 is adapted to receive the reset signal from the reset unit and restart measurement upon receiving said signal. The reset unit may comprise its own microprocessor and/or be adapted to react to a certain threshold value read from the memristive unit. In the latter case the reset unit may be a threshold circuit.

The reset functionality may be needed because of the properties of some memristive units 14. If e.g. a memristive component is used in the memristive unit 14, the memristive component may have a threshold value after which its internal state (e.g. conductivity) stops changing based on the applied electric signal 13, which means the memristive component can no longer produce a cumulative value 15 over time. When the memristive unit 14 receives the reset signal 17, the memristive unit 14 returns to an original state or switches to a predetermined state before continuing to produce a cumulative value 15 of the received electrical signal 13. The reset signal 17 may be, for example, a single electric pulse with programmed voltage polarity, amplitude, and pulse duration, or a series of electric pulses with programmed frequency and number of pulses.

According to an example, the sensing unit 11 and the memristive unit 14 can be e.g. separate modules of a single device 18, schematically illustrated with a dashed line on Fig. 1.

In an example shown on Fig. 1b, the sensing unit and the memristive unit (shown by letters S and M) form a device 18. In other words, the sensing unit 11 and memristive unit 14 can be implemented as regions of one device 18, e.g. a sensing region and a memristive region (separated on Fig. 1b by a dashed line), and in that case the system comprises the device 18. In an example, the sensing unit 11 and the memristive unit 14 comprise a shared active material 19 which is selected from the group of: transition metal dichalcogenides, partially or fully oxidized transition metal dichalcogenides and graphene-like materials. Such active material 19 may also be the active material of the device 18 formed by the sensing unit 11 and the memristive unit 14. Alternatively, only part of the active material 19 may be shared. The sensing unit 11 and the memristive unit 14 can also have at least one shared electrode. In the example shown on Fig. 1b the electric signal 13 may be received by the memristive region directly via the shared active material 19. The sensing unit 11 and memristive unit 14 may be positioned so as to form a vertical stack or a planar structure.

In an example, the sensing unit 11 and the memristive unit 14 can be physically separated, but electrically coupled to each other. The coupling may be in parallel or in series.

A technical effect of the above examples is economic power consumption of the system. This is because the processor does not need to be activated often to receive inputs of discretely measured parameter values, and because the integration or production of cumulative values is performed by the memristive unit 14 instead of the processing unit 16. The processing unit 16 may remain inactive for longer periods of time which contributes to the power saving.

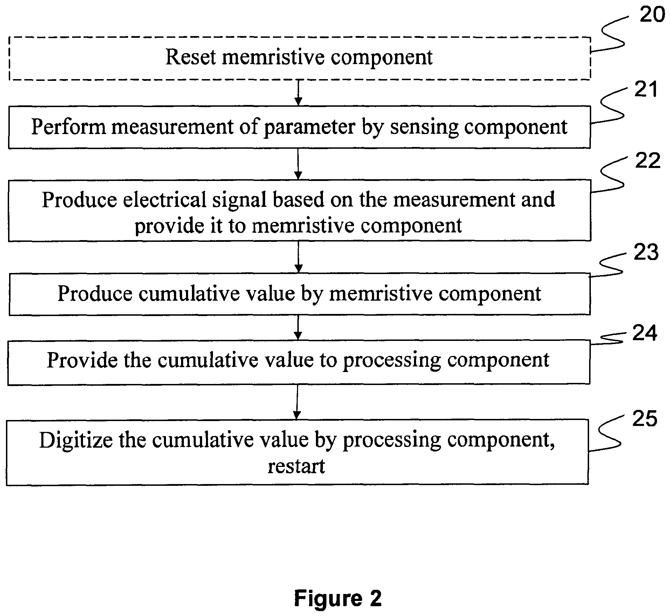

Fig. 2 is a schematic illustration of a method according to an example. According to the method, a measurement of a parameter is performed at 21 by a sensing component. The measurement is then translated into an electrical signal, i.e. the signal is produced based on the measurement. The electrical signal is sent to a memristive component, as indicated at 22. After this, a cumulative value of the provided signal is produced by the memristive component at 23. The cumulative value can be produced as described above in relation to the system example. The produced cumulative value is then provided to a processing component by the memristive component at 24, and the processing component digitizes the cumulative value at 25. The method may also include an optional step of resetting the memristive component to restart the measurement, as shown at 20. In an example, the memristive component is reset upon reaching of a threshold. In an example, the memristive component can be reset periodically. According to an example the resetting can be done by the processing component. Alternatively, according to an example the memristive component may be reset by a separate resetting component.

In an example, if two or more memristive components are used, the method may further comprise switching between the memristive components by a switching component to provide selective coupling of the memristive components to the processing component.

The methods and systems according to the examples above can be used in electronic devices which can potentially benefit from the cumulative sensing. Examples of such devices include devices with sensing abilities such as: smartphones, wearables, fitness trackers, e-skin devices, e-nose devices, stand-alone sensors like monitors for temperature conditions, air cleanness etc. Car electronics may also take advantage of the methods and systems described above. These methods and systems may also potentially be utilized in concepts such as Internet-Of-Things, SmartCity, SmartHouse etc.

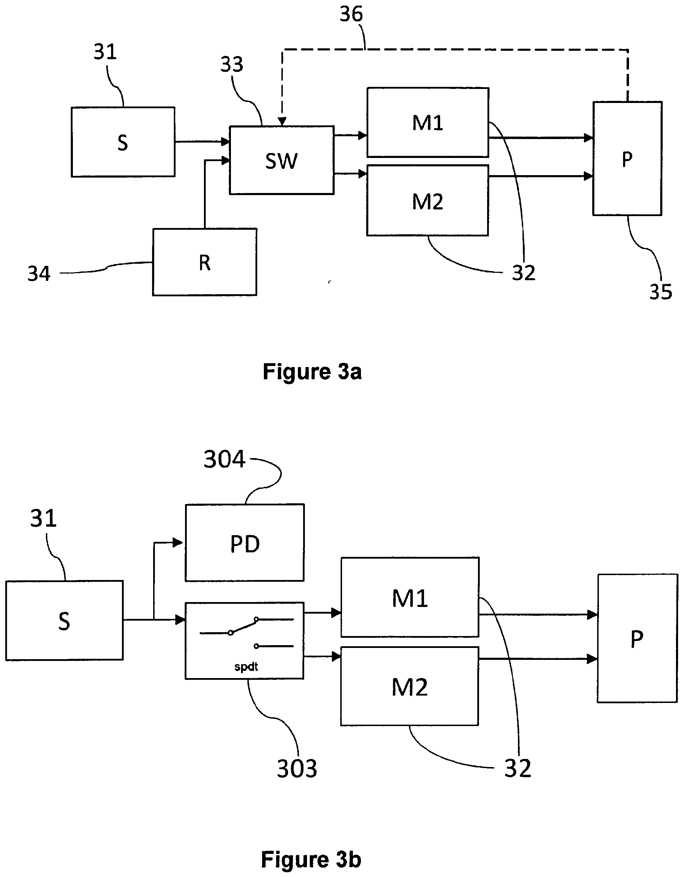

Fig. 3a shows an apparatus according to an example embodiment. The apparatus comprises a sensing component 31 adapted to perform measurement of a parameter and produce an electrical signal based on the measurement. The apparatus also comprises two memristive components 32, a switching component 33 and a resetting component 34. The memristive components 32 are adapted to receive the produced electrical signal from the sensing component 31, and produce a cumulative value of the received electrical signal over time; and the switching component 33 selectively couples the two memristive components 32 to the sensing component 31 and the reset component 34. The apparatus further comprises a processing component 35 electrically coupled to the two memristive components 32 in parallel. The processing unit 35 is adapted to receive the produced cumulative value from the two memristive components 32 and digitize the received cumulative value. In the example of Fig. 3a, the switching component 33 can be a crossover switch and commute between the resetting component 34 and sensing component 31 in a way that allows at least one memristive component of 32 to be coupled to the sensing component 31 all the time. This provides an effect of not losing the effective signal even for small periods of time when resetting takes place. The processing unit 35 may also provide a control signal 36 to the switching component. For example, in one position the input from the sensing component 31 can be connected with the first memristive component; and the resetting component 34 can be connected to the second memristive component to reset its state. The other position then provides an opposite combination.

Fig. 3b schematically shows another apparatus according to an embodiment of the present invention. In this embodiment, the output of the sensing component 31 can be of opposite polarities. The apparatus also includes two memristive components 32 connected in parallel. In addition, the apparatus of this embodiment comprises a single pole double throw switch 303 and a polarity detector 304, wherein the switch 303 can be controlled by the polarity detector 304 depending on the polarity of the signal from the sensing component 31.

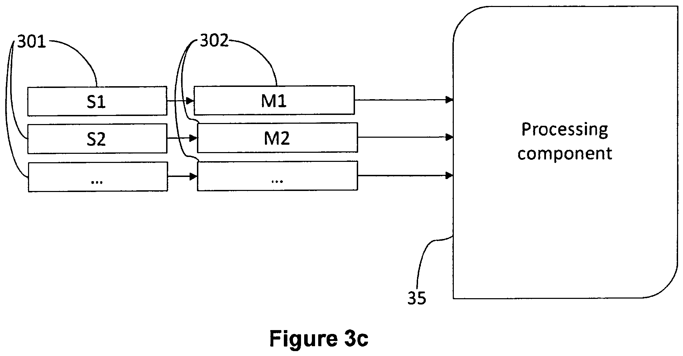

Fig. 3c shows an example according to which an apparatus comprises two or more pairs of a sensing component 301 electrically coupled to a memristive component 302 in series. The sensing components 301 are adapted to perform measurement of a parameter and produce an electrical signal based on the measurement. In an example, all the sensing components 301 may be tuned for different amplification. The memristive components 302 are adapted to receive the produced electrical signal from the sensing component 301 of the same pair, and produce a cumulative value of the received electrical signal over time. The apparatus further comprises a processing component 35 adapted to receive the produced cumulative value from the memristive components and digitize the received cumulative value, wherein the processing component 35 is electrically coupled to the two or more pairs in parallel, as shown on Fig. 3c.

This example provides the ability to measure values of a wide range of amplitudes without overflowing and with precision.

An apparatus in accordance with the invention may include at least one processor in communication with a memory or memories. The processor may store, control, add and/or read information from the memory. The memory may comprise one or more computer programs which can be executed by the processor. The processor may also control the functioning of the apparatus. The processor may control other elements of the apparatus by effecting control signaling. The processor may, for example, be embodied as various means including circuitry, at least one processing core, one or more microprocessors with accompanying digital signal processor(s), one or more processor(s) without an accompanying digital signal processor, one or more coprocessors, one or more multi-core processors, one or more controllers, processing circuitry, one or more computers, various other processing elements including integrated circuits such as, for example, an application specific integrated circuit (ASIC), or field programmable gate array (FPGA), or some combination thereof. Signals sent and received by the processor may include any number of different wireline or wireless networking techniques.

The memory can include, for example, volatile memory, non-volatile memory, and/or the like. For example, volatile memory may include Random Access Memory (RAM), including dynamic and/or static RAM, on-chip or off-chip cache memory, and/or the like. Non-volatile memory, which may be embedded and/or removable, may include, for example, read-only memory, flash memory, magnetic storage devices, for example, hard disks, floppy disk drives, magnetic tape, etc., optical disc drives and/or media, non-volatile random access memory (NVRAM), and/or the like. If desired, the different functions discussed herein may be performed in a different order and/or concurrently with each other. Furthermore, if desired, one or more of the above-described functions may be optional or may be combined.

The abovementioned examples and embodiments provide the technical effect of precise sensing of a cumulative value of a parameter that continuously changes with time. This is because numeric interpolation of the signal is not necessary. Some or all of the above examples and embodiments can also provide the technical effect of not losing any part of the continuous signal to be produced and digitized.

The systems, methods and apparatuses according to the above examples and embodiments may be used in measuring electrical circuits of electronic devices, adaptive electronics, neuromorphic electronics, flexible electronics, and advanced electronic devices with multiple functions (such as e-skin and e-nose). The present invention can be used in devices which are required to function with limited power consumption and computational resources.

Although various aspects of the invention are set out in the independent claim, other aspects of the invention comprise other combinations of features from the described embodiments and/or the dependent claims with the features of the independent claim, and not solely the combinations explicitly set out in the claims.

It is also noted herein that the above description of examples and embodiments should not be viewed in a limiting sense. Rather, there are several variations and modifications which may be made without departing from the scope of the present invention as defined in the appended claims.

## Claims

1. An apparatus, comprising:
a sensing component (31) adapted to perform measurement of a parameter and produce an electrical signal based on the measurement;
two memristive components (M1, M2) adapted to receive the produced electrical signal from the sensing component, and produce a respective cumulative value of the received electrical signal over time;
a switching component (33, 303) adapted to selectively couple the two memristive components to the sensing component; and
a processing component (35) adapted to receive the produced cumulative value from the two memristive components and digitize the received cumulative value, wherein the two memristive components are electrically coupled to the processing component in parallel.

2. The apparatus of claim 1, further comprising a reset component (34) adapted to send a reset signal to the switching component.

3. The apparatus of claim 2, wherein the switching component comprises a crossover switch electrically coupled to the two memristive components, the processing component and the reset component.

4. The apparatus of claim 3, wherein the processing component is adapted to provide a control signal to the crossover switch.

5. The apparatus of claim 4, wherein the crossover switch is adapted to receive the control signal from the processing component and selectively couple the two memristive components to the sensing component and the reset component.

6. The apparatus of claim 5, wherein the two memristive components are adapted to receive the reset signal from the reset component when coupled to the reset component and restart measurement upon receiving said signal.

7. The apparatus of claim 1, further comprising a polarity detector (304) electrically coupled to the sensing component and the switching component.

8. The apparatus of claim 7, wherein the sensing component is adapted to produce electrical signals of opposite polarities based on the measurement of the parameter.

9. The apparatus of claim 8, wherein the switching component comprises a single pole double throw switch.

10. The apparatus of claim 9, wherein the polarity detector is adapted to detect the polarity of the electrical signal produced by the sensing component, and control the single pole double throw switch based on the detected polarity.

## Patentansprüche

1. Vorrichtung, umfassend:
eine Abtastkomponente (31), angepasst, um die Messung eines Parameters durchzuführen und ein elektrisches Signal basierend auf der Messung zu erzeugen;
zwei memristive Komponenten (M1, M2), die angepasst sind, um das erzeugte elektrische Signal von der Sensorikkomponente zu empfangen und einen entsprechenden kumulativen Wert des empfangenen elektrischen Signals im Laufe der Zeit zu erzeugen;
eine Schaltkomponente (33, 303), die angepasst ist, um die beiden memristiven Komponenten selektiv mit der Sensorkomponente zu kuppeln; und
eine Verarbeitungskomponente (35), die angepasst ist, um den erzeugten kumulativen Wert von den beiden speichernden Komponenten zu empfangen und den empfangenen kumulativen Wert zu digitalisieren, wobei die beiden speichernden Komponenten elektrisch mit der Verarbeitungskomponente parallel gekoppelt sind.

2. Vorrichtung nach Anspruch 1, ferner umfassend eine Rückstellkomponente (34), die geeignet ist, ein Rückstellsignal an die Schaltkomponente zu senden.

3. Vorrichtung nach Anspruch 2, wobei die Schalteinheit einen Frequenzweichenschalter umfasst, der elektrisch mit den beiden memristiven Komponenten, der Verarbeitungskomponente und der Rückstellkomponente, gekoppelt ist.

4. Vorrichtung nach Anspruch 3, wobei die Verarbeitungskomponente angepasst ist, um ein Steuersignal für den Frequenzweichenschalter bereitzustellen.

5. Vorrichtung nach Anspruch 4, wobei der Frequenzweichenschalter angepasst ist, um das Steuersignal von der Verarbeitungskomponente zu empfangen und die beiden memristiven Komponenten selektiv mit der Sensorikkomponente und der Rückstellkomponente zu koppeln.

6. Vorrichtung nach Anspruch 5, wobei die beiden memristiven Komponenten angepasst sind, um das Rückstellsignal von der Rückstellkomponente zu empfangen, wenn sie mit der Rückstellkomponente gekoppelt sind und die Messung beim Empfangen des Signals neu starten.

7. Vorrichtung nach Anspruch 1, ferner umfassend einen Polaritätsdetektor (304), der elektrisch mit der Abtastkomponente und der Schaltkomponente gekoppelt ist.

8. Vorrichtung nach Anspruch 7, wobei die Abtastkomponente angepasst ist, um elektrische Signale mit entgegengesetzten Polaritäten basierend auf der Messung des Parameters zu erzeugen.

9. Vorrichtung nach Anspruch 8, wobei die Schalteinheit einen einpoligen Umschalter umfasst.

10. Vorrichtung nach Anspruch 9, wobei der Polaritätsdetektor angepasst ist, um die Polarität des von der Abtastkomponente erzeugten elektrischen Signals zu erfassen und den einpoligen Umschalter basierend auf der erfassten Polarität zu steuern.

## Revendications

1. Appareil, comprenant :
un composant de détection (31) conçu pour effectuer la mesure d'un paramètre et pour produire un signal électrique en fonction de la mesure ;
deux composants memrésistifs (M1, M2), conçus pour recevoir le signal électrique produit à partir du composant de détection et pour produire une valeur cumulative respective du signal électrique reçu au cours du temps ;
un composant de commutation (33, 303) conçu pour coupler sélectivement deux composants memrésistifs au composant de détection ; et
un composant de traitement (35), conçu pour recevoir la valeur cumulative produite à partir des deux composants memrésistifs et pour numériser la valeur cumulative reçue, les deux composants memrésistifs étant électriquement couplés au composant de traitement en parallèle.

2. Appareil selon la revendication 1, comprenant en outre un composant de réinitialisation (34) conçu pour envoyer un signal de réinitialisation au composant de commutation.

3. Appareil selon la revendication 2, dans lequel le composant de commutation comprend un commutateur de croisement, couplé électriquement aux deux composants memrésistifs, au composant de traitement et au composant de réinitialisation.

4. Appareil selon la revendication 3, dans lequel le composant de traitement est conçu pour fournir un signal de commande au commutateur de croisement.

5. Appareil selon la revendication 4, dans lequel le commutateur de croisement est conçu pour recevoir le signal de commande à partir du composant de traitement et pour coupler sélectivement les deux composants memrésistifs au composant de détection et au composant de réinitialisation.

6. Appareil selon la revendication 5, dans lequel les deux composants memrésistifs sont conçus pour recevoir le signal de réinitialisation à partir du composant de réinitialisation lorsqu'il est couplé au composant de réinitialisation et pour refaire la mesure lors de la réception dudit signal.

7. Appareil selon la revendication 1, comprenant en outre un détecteur de polarité (304) électriquement couplé au composant de détection et au composant de commutation.

8. Appareil selon la revendication 7, dans lequel le composant de détection est conçu pour produire des signaux électriques de polarités opposées en fonction de la mesure du paramètre.

9. Appareil selon la revendication 8, dans lequel le composant de commutation comprend un commutateur unipolaire à deux directions.

10. Appareil selon la revendication 9, dans lequel le détecteur de polarité est conçu pour détecter la polarité du signal électrique produit par le composant de détection, et pour commander le commutateur unipolaire à deux directions en fonction de la polarité détectée.
